(19) Europäisches Patentamt
European Patent Office
Office européen des brevets

(11) EP 2 770 592 A2

(12) EUROPEAN PATENT APPLICATION

(43) Date of publication:
27.08.2014 Bulletin 2014/35

(51) Int Cl.:
H01S 5/20 (2006.01)   H01S 5/065 (2006.01)
H01S 5/343 (2006.01)   H04N 9/31 (2006.01)
H01S 5/22 (2006.01)   H01S 5/34 (2006.01)

(21) Application number: 14000290.8

(22) Date of filing: 28.01.2014

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 25.02.2013 JP 2013034821

(71) Applicant: Sony Corporation
Tokyo 108-0075 (JP)

(72) Inventor: Abe, Hiroaki
Tokyo 108-0075 (JP)

(74) Representative: Müller - Hoffmann & Partner
Patentanwälte
St.-Martin-Strasse 58
81541 München (DE)

(54) **Semiconductor light emitting element and display device**

(57)     A semiconductor light emitting element is provided in which an optical intensity distribution of light to be emitted is the normal distribution and which can form a highly fine image with reduced speckle formation. In the semiconductor light emitting element, first regions (21) and second regions (22) are periodically and alternately arranged in an optical waveguide (20) along an extending direction thereof, and when the number of the first regions (21) and the number of the second regions are represented by $P_1$ and $P_2$, respectively, if $(P_1-P_2)=1$, $P_2$ is an integer of 2 or more, and if $(P_2-P_1)=1$, $P_1$ is an integer of 2 or more. In addition, the effective refractive index (neff-1) of the first region (21) is different from the effective refractive index (neff-2) of the second region (22), the width (W1) of the first region (21) is different from the width (W2) of the second region, (22) or two types of light in a fundamental transverse mode are emitted.

## FIG. 1A

**Description**

CROSS REFERENCE TO RELATED APPLICATIONS

This application claims the benefit of Japanese Priority Patent Application JP 2013-034821 filed February 25, 2013.

BACKGROUND

The present disclosure relates to a semiconductor light emitting element and a display device including the semiconductor light emitting element.

A display device, such as a projector device including a semiconductor light emitting element formed of a semiconductor laser element as a light source, that is, a so-called laser display device, has been disclosed, for example, in Japanese Unexamined Patent Application Publication No. 2009-025462. Since being compact and lightweight and having a feature of low electrical power consumption besides a high luminance and a high definition, the laser display device has drawn significant attention. However, in the laser display device, a speckle noise has been partially but not totally responsible for degradation in quality of various types of images. This speckle noise is generated by a phenomenon in which because of a high coherence of laser light, scattered light beams thereof interfere with each other on a laser irradiation surface, such as a screen or a wall surface, on which various types of images are to be displayed, and this phenomenon is caused by the presence of fine irregularities of the laser irradiation surface. Incidentally, a speckle contrast C can be represented by the following equation (1) when the wavelength of laser light, the surface roughness of the laser irradiation surface, and the oscillation wavelength width of laser light are represented by $\lambda$, $\sigma_h$, and $\Delta\lambda$, respectively. In addition, it is found that from the equation (1), as the value of the oscillation wavelength width $\Delta\lambda$ is increased, the reduction in speckle noise can be performed.

$$C = [1 / \{2(2 \cdot \pi \cdot \sigma_h \cdot \Delta\lambda / \lambda^2)^2 + 1\}]^{1/4} \qquad (1)$$

A semiconductor light emitting element which reduces a speckle noise has been disclosed in Japanese Unexamined Patent Application Publication No. 2010-171316. The semiconductor light emitting element disclosed in the above patent document includes: an active multimode waveguide which allows light in a fundamental transverse mode and light in a first-order transverse mode to pass therethrough; and an active layer having a first active layer region in which the fundamental transverse mode is distributed more than the first-order transverse mode and a second active layer region in which the first-order transverse mode is distributed more than the fundamental transverse mode. In addition, in this semiconductor light emitting element described above, the light emission wavelength of the first active layer region is different from that of the second active layer region.

SUMMARY

In the semiconductor light emitting element disclosed in Japanese Unexamined Patent Application Publication No. 2010-171316, the fundamental transverse mode and the first-order transverse mode are alternately oscillated. In this case, since the oscillation wavelengths are different from each other, the oscillation spectrum is widened on the time-average basis, the coherence of laser light is reduced, and hence the speckle noise can be reduced. However, since the optical intensity distribution of the first-order transverse mode is not the normal distribution, the light collection properties are degraded, and as a result, a highly fine image may not be disadvantageously obtained.

Accordingly, it is desirable to provide a semiconductor light emitting element which emits light, the optical intensity distribution of which is the normal distribution, and which can display a highly fine image, and it is also desirable to provide a display device including the semiconductor light emitting element described above.

Various respective aspects and features of the invention are defined in the appended claims.

According to a first embodiment of the present disclosure, there is provided a semiconductor light emitting element in which first regions and second regions are periodically and alternately arranged in an optical waveguide along an extending direction thereof; when the number of the first regions and the number of the second regions are represented by $P_1$ and $P_2$, respectively, if $(P_1 - P_2) = 1$ holds, $P_2$ is an integer of 2 or more, and if $(P_2 - P_1) = 1$ holds, $P_1$ is an integer of 2 or more; and an effective refractive index of the first region is different from an effective refractive index of the second region.

According to a second embodiment of the present disclosure, there is provided a semiconductor light emitting element in which first regions and second regions are periodically and alternately arranged in an optical waveguide along an extending direction thereof; when the number of the first regions and the number of the second regions are represented by $P_1$ and $P_2$, respectively, if $(P_1-P_2)=1$ holds, $P_2$ is an integer of 2 or more, and if $(P_2-P_1)=1$ holds, $P_1$ is an integer of 2 or more; and the width of the first region is different from the width of the second region.

According to a third embodiment of the present disclosure, there is provided a semiconductor light emitting element in which first regions and second regions are periodically and alternately arranged in an optical waveguide along an extending direction thereof; when the number of the first regions and the number of the second regions are represented by $P_1$ and $P_2$, respectively, if $(P_1-P_2)=1$ holds, $P_2$ is an integer of 2 or more, and if $(P_2-P_1)=1$ holds, $P_1$ is an integer of 2 or more; and two types of light in a fundamental transverse mode are emitted.

According to a fourth embodiment of the present disclosure, there is provided a display device including one of the semiconductor light emitting elements according to the first to the third embodiments of the present disclosure.

In the semiconductor light emitting element according to the first embodiment of the present disclosure, the first regions and the second regions are periodically and alternately arranged, and the effective refractive index of the first region is different from the effective refractive index of the second region, and in the semiconductor light emitting element according to the second embodiment of the present disclosure, the first regions and the second regions are periodically and alternately arranged, and the width of the first region is different from the width of the second region; hence, a wavelength $\lambda_2$ of light in a fundamental transverse mode generated in the second region is different from a wavelength $\lambda_1$ of light in a fundamental transverse mode generated in the first region. In addition, in the semiconductor light emitting element according to the third embodiment of the present disclosure, in the first regions and the second regions, the two types of light in a fundamental transverse mode are generated. In this case, the value of $P_1$ or $P_2$ is an integer of 2 or more. Incidentally, when light in a fundamental transverse mode generated in one of the first region and the second region is propagated through the other region of the optical waveguide, the light is coupled with light in a fundamental transverse mode generated in the other region (energy conversion is performed). That is, for example, light in a fundamental transverse mode generated in the second region is generally absorbed, in a way, in light in a fundamental transverse mode generated in the first region. Hence, in the semiconductor light emitting elements according the first to the third embodiments of the present disclosure, for example, if $(P_1-P_2)=1$ holds, since at least two second regions are present, light in a fundamental transverse mode generated in one second region reaches an adjacent second region before coupling with light in a fundamental transverse mode generated in the first region is completed. As a result, two types of light in a fundamental transverse mode (light having a wavelength $\lambda_1$ and light having a wavelength $\lambda_2$) can be present. Accordingly, the value of the wavelength width $\Delta\lambda$ of the total light emitted from the semiconductor light emitting element can be increased. Hence, without using a complicated element structure and/or circuit, by the above equation (1), the speckle noise can be reduced by the semiconductor light emitting element itself. In addition, since the light generated in the first region and the light generated in the second region are each in a fundamental transverse mode, the optical intensity distribution of the total light to be emitted is the normal distribution, and hence a highly fine image can be obtained.

BRIEF DESCRIPTION OF THE DRAWINGS

Fig. 1A is a schematic arrangement view of constituents of a semiconductor light emitting element of Example 1;

Fig. 1B is a schematic cross-sectional view of the semiconductor light emitting element of the Example 1 taken along the arrows IB-IB in Fig. 1A;

Fig. 2A is a schematic cross-sectional view of the semiconductor light emitting element of Example 1 taken along the arrows IIA-IIA in Fig. 1A;

Fig. 2B is a schematic cross-sectional view of a semiconductor light emitting element of Example 2 similar to that taken along the arrows IIB-IIB in Fig. 1A;

Figs. 3A and 3B are each a schematic partial cross-sectional view including a substrate to illustrate a method for manufacturing the semiconductor light emitting element of Example 1;

Figs. 4A and 4B are each a schematic partial cross-sectional view illustrating the method for manufacturing the semiconductor light emitting element of Example 1 following the cross-sectional views shown in Figs. 3A and 3B;

Fig. 5A is a graph showing measurement results of emission angle distributions obtained when the semiconductor light emitting element of Example 1 is continuously driven;

Fig. 5B is a graph showing measurement results of wavelength spectra obtained when the semiconductor light emitting element of Example 1 is continuously driven;

Figs. 6A and 6B are views illustrating the state in which in Example 3, the value of $\Delta\lambda$ can be increased when a predetermined drive current is allowed to pass through first regions and second regions of an optical waveguide and when a high frequency signal is further superimposed on the current, Fig. 6A shows the case in which continuous oscillation is performed without superimposition of a high frequency signal, and Fig. 6B shows the case in which continuous oscillation is performed with superimposition of a high frequency signal;
Fig. 7 is a schematic arrangement view of constituents of a semiconductor light emitting element of Example 4;
Fig. 8 is a conceptual view of a display device of Example 5; and
Fig. 9 is a conceptual view of another display device of Example 5.

DETAILED DESCRIPTION OF EMBODIMENTS

Hereinafter, with reference to the drawings, although the present disclosure will be described using examples, the present disclosure is not limited thereto, and various numerical values and materials disclosed in the examples are merely shown by way of example. In addition, description will be made in the following order.

1. Description relating to the semiconductor light emitting elements according to the first to the third embodiments of the present disclosure, the display device according to the fourth embodiment of the present disclosure, and the others.
2. Example 1 (the semiconductor light emitting elements according to the first and the third embodiments of the present disclosure)
3. Example 2 (a modification of Example 1)
4. Example 3 (another modification of Example 1)
5. Example 4 (the semiconductor light emitting elements according to the second and the third embodiments of the present disclosure)
6. Example 5 (the display device according to the fourth embodiment of the present disclosure), and the others.

[Description relating to the semiconductor light emitting elements according to the first to the third embodiments of the present disclosure, the display device according to the fourth embodiment of the present disclosure, and the others]

In the following description, the semiconductor light emitting elements according to the first, the second, and the third embodiments of the present disclosure and the semiconductor light emitting element included in the display device according to the fourth embodiment of the present disclosure may be collectively referred to, for example, as the "semiconductor light emitting element according to an embodiment of the present disclosure" in some cases.

The semiconductor light emitting element according to the first or the second embodiment of the present disclosure may be configured to emit two types of light in a fundamental transverse mode.

In the semiconductor light emitting element according to the first embodiment of the present disclosure including the above preferable configuration, when the length of the first region along the extending direction of the optical waveguide is represented by $L_1$, the average wavelength of light to be emitted is represented by $\lambda_{ave}$, the effective refractive index of the first region is represented by $n_{eff-1}$, and the effective refractive index of the second region is represented by $n_{eff-2}$, the following equation is preferably satisfied.

$$0.7 \times \{\lambda_{ave}/(n_{eff-1} - n_{eff-2})\} \leq L_1 \leq 1.3 \times \{\lambda_{ave}/(n_{eff-1} - n_{eff-2})\}$$

In the semiconductor light emitting element according to the first embodiment of the present disclosure including the preferable configuration described above, when the effective refractive index of the first region is represented by $n_{eff-1}$, and the effective refractive index of the second region is represented by $n_{eff-2}$, the following equation is preferably satisfied.

$$1 \times 10^{-3} \leq (n_{eff-1} - n_{eff-2})/n_{eff-1} \leq 1 \times 10^{-2}$$

When the value of $\{(n_{eff-1} - n_{eff-2})/n_{eff-1}\}$ is excessively increased, light in a fundamental transverse mode may not be emitted, the intensity distribution of light beams emitted from the semiconductor light emitting element is deviated from the normal distribution, the light collection properties are degraded, and as a result, a highly fine image may not be obtained in some cases. Hence, the value of $\{(n_{eff-1} - n_{eff-2})/n_{eff-1}\}$ is preferably set as described above so that a higher-order transverse mode is not generated.

In addition, in the semiconductor light emitting element according to the second embodiment of the present disclosure including the above preferable configuration, when the width of the first region and the width of the second region are represented by $W_1$ and $W_2$, respectively, the following equation is preferably satisfied.

$$1.2 \leq W_2/W_1 \leq 2.5$$

Furthermore, for example, in the semiconductor light emitting element according to an embodiment of the present disclosure including the preferable configuration described above, when the total length of the first regions along the extending direction of the optical waveguide and the total length of the second regions along the extending direction of the optical waveguide are represented by $L_1$ and $L_2$, respectively, the following equation is preferably satisfied.

$$0.1 \leq L_2/(L_1+L_2) \leq 0.4$$

Furthermore, for example, in the semiconductor light emitting element according to an embodiment of the present disclosure including the preferable configuration described above, when the maximum peak value of the wavelength of light to be emitted from the semiconductor light emitting element and the wavelength width of the light are represented by $\lambda_{max}$ and $\Delta\lambda$, respectively, in view of reduction in speckle noise, a higher value of $\Delta\lambda/\lambda_{max}$ is more preferable. Although the lower limit of $\Delta\lambda/\lambda_{max}$ is not particularly limited, for example, a value of $1.5\times10^{-4}$ may be mentioned. When the semiconductor light emitting element is formed of a semiconductor laser element, the maximum peak value $\lambda_{max}$ of the wavelength of light to be emitted from the semiconductor light emitting element and the wavelength width $\Delta\lambda$ of the light correspond to the maximum peak value of the oscillation wavelength and the width thereof, respectively, and when the semiconductor light emitting element is formed of a super luminescent diode, the maximum peak value $\lambda_{max}$ of the wavelength of light to be emitted from the semiconductor light emitting element and the wavelength width $\Delta\lambda$ of the light correspond to the maximum peak value of the emission wavelength and the width thereof, respectively.
Furthermore, in the semiconductor light emitting element according to the first embodiment of the present disclosure including the preferable configuration described above, the structure may be formed in which one ridge portion is occupied with the first regions and the second regions, and in the vicinity of each second region (one side or both sides of the ridge portion), a refractive index control region (a refractive index change region, a refractive index disturbance region, a disorder region, or a waveguide loss decrease region) is provided which makes the effective refractive index of the second region different from the effective refractive index of the first region. In addition, in the refractive index control region, a substance (or a substance/impurity which increases the energy bandgap in the refractive index control region) which decreases the refractive index may be contained. In this case, as the substance which decreases the refractive index, for example, zinc oxide (ZnO) may be mentioned, and when zinc oxide is heat-diffused, an active layer is disordered, and the refractive index can be decreased. Alternatively, the refractive index control region may have the structure formed of a metal film. In this case, as a material forming the metal film, for example, Ti, Pt, and Au may be mentioned, and when those materials are each formed into a film, for example, by a vacuum deposition method or a sputtering method, the refractive index can be decreased. As a method for forming the refractive index control region, the following may be mentioned by way of example.

(1) A method in which after a material layer forming the refractive index control region is formed on a compound semiconductor layer, the material layer is patterned and is then heat-diffused to the compound semiconductor layer.
(2) A method in which after a material layer forming the refractive index control region is formed on a compound semiconductor layer, the material layer is patterned.
(3) An ion implantation method.

In addition, in the semiconductor light emitting element according to the second or the third embodiment of the present disclosure including the preferable configuration and structure described above, the structure in which one ridge portion is occupied with the first regions and the second regions may be formed.
Furthermore, for example, in the semiconductor light emitting element according to an embodiment of the present disclosure including the preferable configuration and structure described above, a configuration may be formed in which a predetermined drive current is allowed to pass through the first regions and the second regions of the optical waveguide, and in addition, a high frequency signal (such as 100 to 300 MHz) is superimposed on the current. Accordingly, since fluctuation of the gain is generated, the value of $\Delta\lambda/\lambda_{max}$ can be further increased, and as a result, the reduction in speckle noise can be more effectively achieved.
Furthermore, for example, in the semiconductor light emitting element according to an embodiment of the present disclosure including the preferable configuration and structure described above, a configuration may be formed in which an active layer is provided for the optical waveguide, and the active layer is formed from an AlGaInP-based compound semiconductor, and in this case, the active layer may be configured to have a quantum well structure in which at least one well layer formed of a GaInP layer or an AlGaInP layer and at least two barrier layers each formed of an AlGaInP layer are laminated to each other. Alternatively, a configuration may be formed in which an active layer is provided for the optical waveguide, and the active layer is formed from a GaInN-based compound semiconductor, and in this case, the active layer may be configured to have a quantum well structure in which at lease one well layer formed of a GaInN layer and at least two barrier layers each formed of an GaInN layer having an In composition different from that of the well layer are laminated to each other. A compound semiconductor-laminate structure forming the ridge portion itself may have a common configuration, and in particular, the compound semiconductor-laminate structure is formed on a substrate and includes a first region compound semiconductor layer, an active layer, and a second compound semiconductor layer laminated in this order from a substrate side. A first electrode is connected to the first compound semiconductor layer or the substrate, and a second electrode is connected to the second compound semiconductor layer.

Furthermore, for example, in the semiconductor light emitting element according to an embodiment of the present disclosure including the preferable configuration and structure described above, the semiconductor light emitting element may be formed of a semiconductor laser element or a super luminescent diode (SLD). In this case, in the semiconductor laser element, when the optical reflectance of a light emission surface and the optical reflectance of a light reflection surface are optimized, a resonator may be formed. On the other hand, in the super luminescent diode, when the optical reflectance of a light emission surface is set to a very low value, and the optical reflectance of a light reflection surface is set to a very high value, without forming a resonator, light generated in the active layer is reflected on the light reflection surface and is emitted from the light emission surface. In general, on the light emission surface, an anti-reflection (AR) coating layer or a low-reflection coating layer is formed. In addition, on the light reflection surface, a high-reflection (HR) coating layer is formed. As the anti-reflection coating layer (or the low-reflection coating layer), for example, there may be mentioned a laminate structure formed from at least two types of layers selected from the group consisting of a titanium oxide layer, a tantalum oxide layer, a zirconium oxide layer, a silicon oxide layer, an aluminum oxide layer, an aluminum nitride layer, and a silicon nitride layer.

As the display device according to the fourth embodiment of the present disclosure, for example, a projector device, an image display device, a monitor device, a reflection type liquid crystal display device, a head mount display (HMD), a head up display (HUD), and a laser lighting device, each including a semiconductor light emitting element as a light source, may be mentioned. In addition, the semiconductor light emitting element according to an embodiment of the present disclosure may also be used as a light source of a laser microscope.

As the width $W_1$ of the ridge portion, a width of 1.0 to 2.5 $\mu$m may be mentioned by way of example. Since a higher-order transverse mode may be generated in some cases when the width of the ridge portion is excessively large, the widths $W_1$ and $W_2$ of the ridge portion are preferably determined so as not to generate a higher-order transverse mode. In particular, as the upper limit of the width $W_2$, a width of 3.0 $\mu$m may be mentioned.

As the substrate, for example, there may be mentioned a GaAs substrate, a GaP substrate, an AlN substrate, an AlP substrate, an InN substrate, an InP substrate, an AlGaInN substrate, an AlGaN substrate, an AlInN substrate, an AlGaInP substrate, an AlGaP substrate, an AlInP substrate, a GaInP substrate, a ZnS substrate, a sapphire substrate, a SiC substrate, an alumina substrate, a ZnO substrate, a LiMgO substrate, a LiGaO$_2$ substrate, an MgAl$_2$O$_4$ substrate, a Si substrate, and a Ge substrate. In addition, a substrate prepared by forming a buffer layer or an intermediate layer on a surface (principal surface) of the substrate mentioned above may also be used. In addition, as for the principal surface of the substrate, depending on the crystalline structure (such as a cubic system or a hexagonal system), a crystalline orientation plane, such as a so-called A plane, B plane, C plane, R plane, M plane, N plane, or S plane, or a plane shifted in a specific direction from any of those planes mentioned above, may also be used.

As an n-type impurity added to the compound semiconductor layer forming the compound semiconductor-laminate structure, for example, Silicon (Si), germanium (Ge), selenium (Se), tin (Sn), carbon (C), tellurium (Te), sulfur (S), oxygen (O), and Pd (palladium) may be mentioned, and as a p-type impurity, zinc (Zn), magnesium (Mg), beryllium (Be), cadmium (Cd), calcium (Ca), and barium (Ba) may be mentioned. The active layer may have either a single quantum well structure [QW structure] or a multiquantum well structure [MQW structure]. As a method for forming the compound semiconductor-laminate structure (film formation method), an organometallic chemical vapor phase growth method (MOCVD method or MOVPE method), an organometallic molecular beam epitaxy method (MOMBE method), a hydride vapor phase epitaxial method (HVPE method) in which a halogen contributes for transportation or reaction, and a plasma assisted physical vapor phase growth method (PPD method) may be mentioned. As a method for etching the compound semiconductor-laminate structure to form the ridge portion, for example, a combination between a lithographic technique and a wet etching technique and a combination between a lithographic technique and a dry etching technique may be mentioned.

The compound semiconductor-laminate structure is connected to the first electrode and the second electrode. When the first electrode or the second electrode is formed on the substrate or the compound semiconductor layer having a p-type conductivity, as the electrode (p-side electrode), for example, there may be mentioned Au/AuZn, Au/Pt/Ti(/Au)/AuZn, Au/AuPd, Au/Pt/Ti(/Au)/AuPd, Au/Pt/TiW(/Ti)(/Au)/AuPd, Au/Pt/Ti, or Au/Ti. In addition, when the first electrode or the second electrode is formed on the substrate or the compound semiconductor layer having an n-type conductivity, as the electrode (n-side electrode), for example, there may be mentioned Au/Ni/AuGe, Au/Pt/Ti(/Au)/Ni/AuGe, or Au/Pt/TiW(/Ti)/Ni/AuGe. In addition, the former layer of the " / " shown above is located apart from the active layer from an electrical point of view. Although the first electrode is electrically connected to the first compound semiconductor layer, the case in which the first electrode is formed on the first compound semiconductor layer or the case in which the first electrode is connected to the first compound semiconductor layer with an electrically conductive material layer or an electrically conductive substrate interposed therebetween is also included. The first electrode and the second electrode may be formed, for example, by various types of PVD methods, such as a vacuum deposition method and a sputtering method. In order to electrically connect an external electrode or a circuit to the first electrode and/or the second electrode, a pad electrode may also be provided. The pad electrode preferably has a single layer structure or a multilayer structure, each containing at least one type of metal selected from the group consisting of titanium (Ti), aluminum (Al), platinum (Pt), gold (Au), and nickel (Ni). Alternatively, the pad electrode may also be formed to have a multilayer structure, such as a Ti/Pt/Au multilayer structure or a Ti/Au multilayer structure.

Example 1

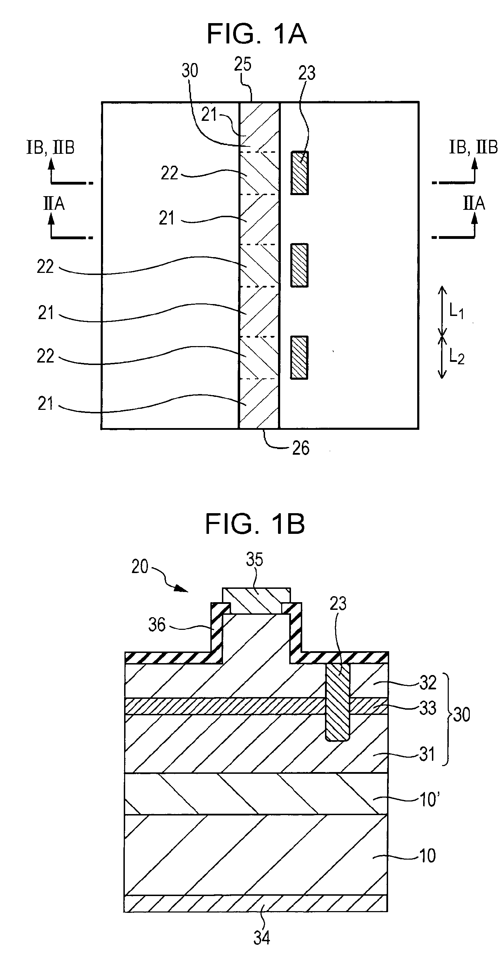

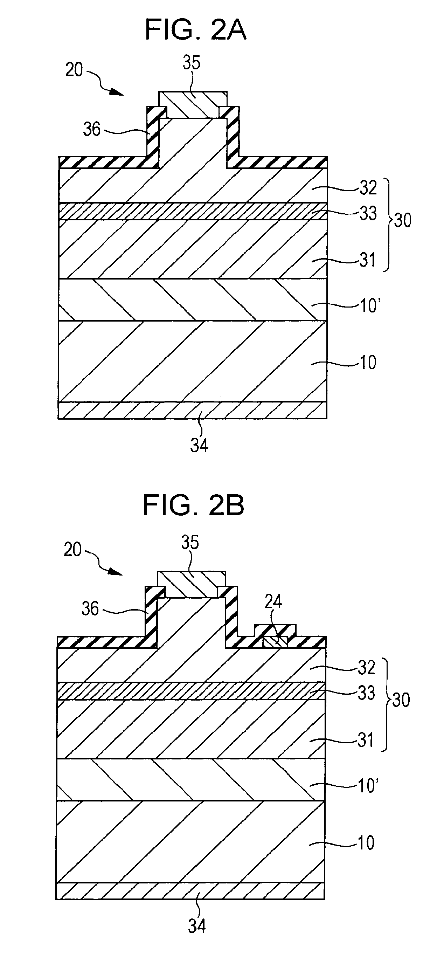

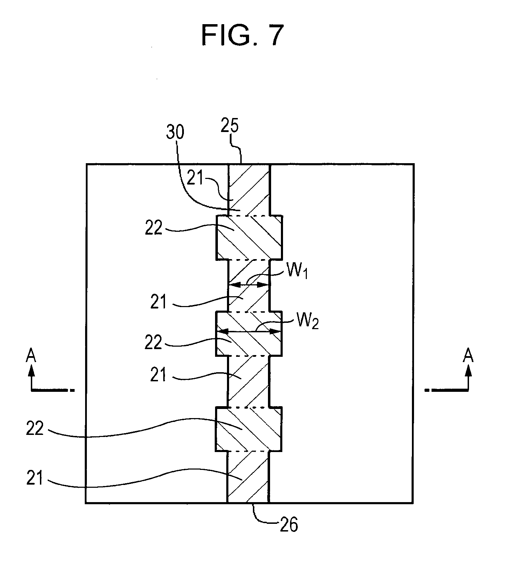

Example 1 relates to the semiconductor light emitting element according to the first and the third embodiments of the present disclosure. A schematic arrangement view of constituents of the semiconductor light emitting element of Example 1 is shown in Fig. 1A, a schematic cross-sectional view of the semiconductor light emitting element of Example 1 taken along the arrows IB-IB of Fig. 1A is shown in Fig. 1B, and a schematic cross-sectional view of the semiconductor light emitting element of Example 1 taken along the arrows IIA-IIA of Fig. 1A is shown in Fig. 2A. In addition, in Fig. 1A, in order to clearly show the first region, the second region, and the refractive index control region, those regions are hatched with slant lines. As in the case described above, in Fig. 7 which will be described later, in order to clearly show the first region and the second region, those regions are also hatched with slant lines.

The semiconductor light emitting element (in particular, a semiconductor laser element) of Example 1 will be described with reference to the semiconductor light emitting element according to the first embodiment of the present disclosure. First regions 21 and second regions 22 are periodically and alternately arranged in an optical waveguide (in particular, a ridge portion 20) along an extending direction thereof, and when the number of the first regions 21 and the number of the second regions 22 are represented by $P_1$ and $P_2$, respectively, if $(P_1-P_2)=1$, $P_2$ is an integer of 2 or more, and if $(P_2-P_1)=1$, $P_1$ is an integer of 2 or more. In addition, the effective refractive index $n_{eff-1}$ of the first region 21 is different from the effective refractive index $n_{eff-2}$ of the second region 22. In addition, the semiconductor light emitting element of Example 1 emits two types of light in a fundamental transverse mode (the semiconductor light emitting element of each of Examples 2 to 4 described later also has the same performance as described above). Alternatively, the semiconductor light emitting element of Example 1 will be described with reference to the semiconductor light emitting element according to the third embodiment of the present disclosure. First regions 21 and second regions 22 are periodically and alternately arranged in an optical waveguide (in particular, a ridge portion 20) along an extending direction thereof, and when the number of the first regions 21 and the number of the second regions 22 are represented by $P_1$ and $P_2$, respectively, if $(P_1-P_2)=1$, $P_2$ is an integer of 2 or more, if $(P_2-P_1)=1$, $P_1$ is an integer of 2 or more. In addition, the semiconductor light emitting element of Example 1 emits two types of light in a fundamental transverse mode. In this case, in particular, the value of $P_1$ is "4", and the value of $P_2$ is "3". In Examples 2 to 4 which will be described later, as is the case described above, $P_1$ is set to 4, and $P_2$ is set to 3. In addition, the effective refractive index $n_{eff-1}$ of the first region 21 is determined by an active layer, a clad layer, a ridge depth, and an oscillation wavelength. On the other hand, ZnO is diffused to a position in the vicinity of the side of the ridge portion 20 to disorder the active layer, so that the refractive index of the second region 22 is decreased. Hence, the effective refractive index $n_{eff-2}$ of the second region 22 is decreased lower than that of the first region 21. The decrease in refractive index caused by this disordering is determined by a diffusion depth, and this diffusion depth can be controlled by a diffusion temperature and a diffusion time.

Furthermore, in the semiconductor light emitting element of Example 1, when the length of the first region 21 along the extending direction of the optical waveguide (ridge portion 20) is represented by $L_1$, and the average wavelength of light to be emitted is represented by $\lambda_{ave}$, the following equation is satisfied.

$$0.7 \times \{\lambda_{ave}/(n_{eff-1}-n_{eff-2})\} \leq L_1 \leq 1.3 \times \{\lambda_{ave}/(n_{eff-1}-n_{eff-2})\}$$

In particular, $L_1=\lambda_{ave}/(n_{eff-1}-n_{eff-2})$ holds.
Alternatively, the following equation is satisfied.

$$1 \times 10^{-3} \leq (n_{eff-1}-n_{eff-2})/n_{eff-1} \leq 1 \times 10^{-2}$$

In addition, when the total length of the first regions 21 along the extending direction of the optical waveguide (ridge portion 20) and the total length of the second regions 22 along the extending direction of the optical waveguide (ridge portion 20) are represented by $L_1$ and $L_2$, respectively, the following equation is satisfied.

$$0.1 \leq L_2/(L_1+L_2) \leq 0.4$$

Furthermore, when the maximum peak value of the wavelength of light to be emitted from the semiconductor light emitting element and the wavelength width of the light are represented by $\lambda_{max}$ and $\Delta\lambda$, respectively, the following equation is satisfied.

$$\Delta\lambda/\lambda_{max} \geq 1.5 \times 10^{-4}$$

In more particular, in the semiconductor light emitting element of Example 1, the total length of the ridge portion 20 is 1.00 mm, and the width of the ridge portion 20 is 1.8 $\mu$m. In addition, the other physical values are as shown below.

$$n_{eff-1}=3.2700$$

$$n_{eff-2}=3.2655$$

$$\lambda_{ave}=648.75 \ nm$$

$$\lambda_{max}=650.0 \ nm \ (=\lambda_1)$$

$$\lambda_2=647.5 \ nm$$

$$\Delta\lambda=2.5 \ nm$$

$$L_1=185 \ \mu m$$

$$L_2=90 \ \mu m$$

Although an anti-reflection (AR) coating layer or a low reflection coating layer is formed on a light emission surface 25, and a high reflection (HR) coating layer is formed on a light reflection surface 26, those coating layers are omitted in the drawings.

In Example 1, one ridge portion 20 is occupied with the first regions 21 and the second regions 22. In addition, in the vicinity of the second region 22, a refractive index control region (a refractive index change region, a refractive index disturbance region, a disorder region, or a waveguide loss decrease region) 23 is formed which makes the effective refractive index $n_{eff-2}$ of the second region 22 different from the effective refractive index $n_{eff-1}$ of the first region 21. The refractive index control region 23 is formed 2 $\mu$m apart from one side of the ridge portion 20. The length of the refractive index control region 23 along the extending direction of the optical waveguide (ridge portion 20) is 90 $\mu$m, and the width of the refractive index control region 23 is 20 $\mu$m. In Example 1, in the refractive index control region 23, a substance decreasing the refractive index (substance/impurity increasing the bandgap in the refractive index control region 23), in particular, zinc oxide (ZnO), is contained.

In Example 1, as a substrate 10, an n-GaAs substrate is used. In addition, the semiconductor light emitting element of Example 1 emits red light. In this case, an active layer 33 is provided for the optical waveguide (ridge portion 20), and the active layer 33 is formed of an AlGaInP-based compound semiconductor. In addition, the active layer 33 has a quantum well structure in which at least one well layer formed of a GaInP layer or an AlGaInP layer and at least two barrier layers each formed of an AlGaInP layer are laminated to each other. The structure of a compound semiconductor-laminate structure 30 formed of a GaPInP-based compound semiconductor of the semiconductor light emitting element of Example 1 is shown in the following Table 1, and the compound semiconductor layer described in the lowermost column is formed on the substrate 10. The active layer 33 has a multiquantum well structure, and in particular, the barrier layer is configured to include four layers, and the well layer is configured to include three layers. The structure described above is the same as that in Examples 2 to 4 which will be described later.

Table 1

| | Contact layer | p-GaAs |
|---|---|---|
| Second compound semiconductor layer 32 | Second clad layer | p-AlInP |
| | Second guide layer | AlGaInP |
| Active layer 33 | Well layer/Barrier layer | GaInP/AlGaInP |
| First compound semiconductor layer 31 | Firs guide layer | AlGaInP |
| | First clad layer | n-AlInP |
| Buffer layer 10' | | GaInP |

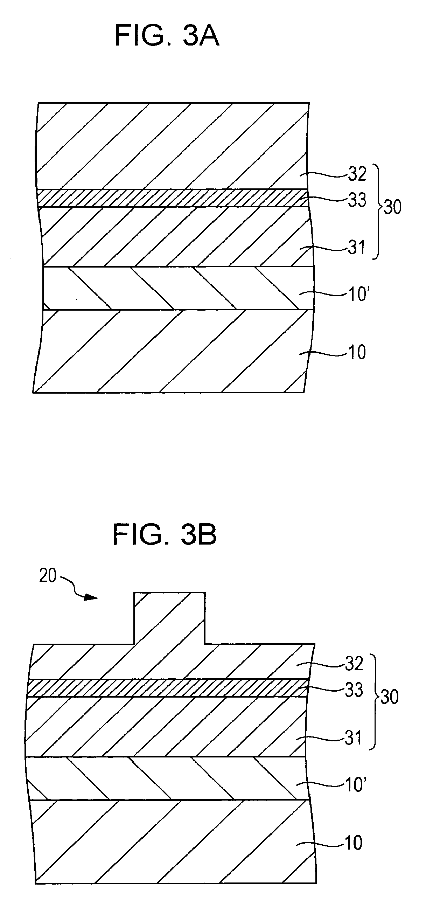

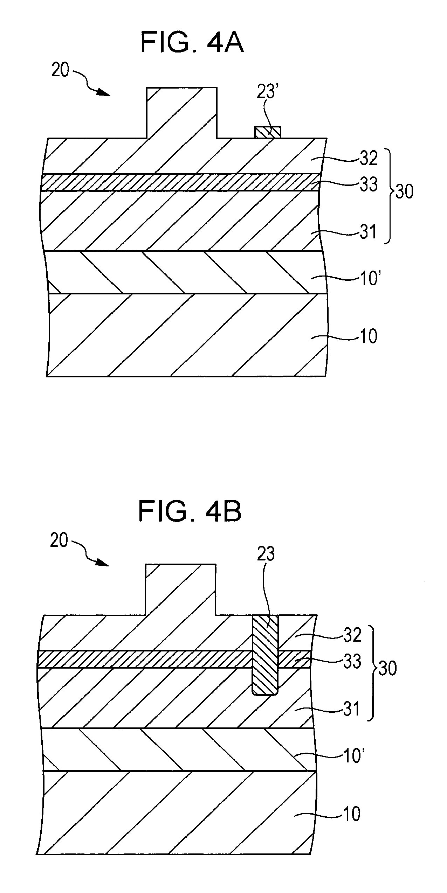

Hereinafter, with reference to Figs. 3A, 3B, 4A, and 4B which are schematic partial cross-sectional views each similar to that taken along the arrows IB-IB in Fig. 1A, a method for manufacturing the semiconductor light emitting element of Example 1 will be described.

[Step-100]

First, on the substrate 10, the compound semiconductor-laminate structure 30 including the active layer 33 is formed. In particular, although various types of compound semiconductor layers are crystal-grown by an MOCVD method, in this case, for example, phosphine (PH$_3$) may be used as a phosphorous raw material, a trimethyl gallium (TMG) gas or a triethyl gallium (TEG) gas may be used as a gallium raw material, a trimethyl aluminum (TMA) gas may be used as an aluminum raw material, a trimethyl indium (TMI) gas may be used as an In raw material, a monosilane gas (SiH$_4$ gas) may be used as a silicon raw material, and a cyclopentadienyl magnesium gas may be used as a Mg source. In more particular, on a principal surface of the substrate 10 formed of an n-GaAs substrate, the buffer layer 10', the first compound semiconductor layer 31, the active layer 33, and the second compound semiconductor layer 32 are epitaxial-grown by a general MOCVD method, that is, by a MOCVD method using an organic metal and/or a hydrogen compound as a raw material gas. Accordingly, the structure shown in a schematic partial cross-sectional view of Fig. 3A can be obtained.

[Step-110]

Subsequently, based on common photolithographic and etching techniques, the compound semiconductor-laminate structure 30 is partially etched, so that a ridge portion 20 having a predetermined width is formed. In particular, a predetermined portion of the second compound semiconductor layer 32 is etched in a thickness direction thereof, so that the part of the second compound semiconductor layer 32 in the thickness direction is removed. Accordingly, the ridge portion 20 can be formed as shown in Fig. 3B.

[Step-120]

Next, in order to make the effective refractive index $n_{eff-2}$ of the second region 22 different from the effective refractive index $n_{eff-1}$ of the first region 21, the refractive index control region 23 is provided in the vicinity of the second region 22. In particular, by a lift-off method, a ZnO layer 23' is formed on an exposed portion of the second compound semiconductor layer 32 located in the vicinity of the second region 22 (see Fig. 4A). Subsequently, when the entire substrate is heated so as to diffuse ZnO by heat, the portion of the compound semiconductor-laminate structure 30 in which the refractive index control region 23 is to be formed is mixed-crystallized, and as a result, the refractive index control region 23 can be provided (see Fig. 4B). The energy bandgap of the portion of the compound semiconductor-laminate structure 30 containing ZnO is increased, and hence the refractive index is decreased. As a result, the whole effective refractive index $n_{eff-2}$ of the second region 22 becomes lower than the whole effective refractive index $n_{eff-1}$ of the first region 21.

[Step-130]

Next, an insulating layer 36 of $SiO_2$, SiN, or $Al_2O_3$ is formed (film formation) on the entire surface by a CVD method. In addition, the insulating layer 36 on the top surface of the second compound semiconductor layer 32 is removed by photolithographic and etching techniques, and by a lift-off method, a second electrode 35 is formed from the exposed top surface of the second compound semiconductor layer 32 onto the insulating layer 36. In addition, by a common method, a first electrode 34 is formed on the rear surface of the substrate 10. Accordingly, the semiconductor light emitting element of Example 1 can be obtained (see Fig. 1B).

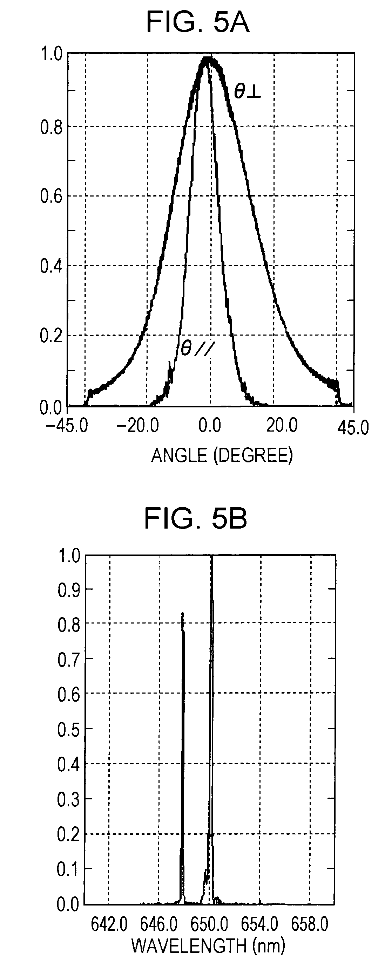

The results of the emission angle distribution and the wavelength spectrum obtained when the semiconductor light emitting element of Example 1 is continuously driven are shown in Fig. 5A and 5B, respectively. As for the emission angle, the vertical emission angle and the horizontal emission angle each show the normal distribution, and hence it is confirmed that two types of laser light oscillate in a fundamental transverse mode. In addition, the oscillation wavelength widths $\Delta\lambda$ of the two types of laser light are each 2.5 nm.

In the semiconductor light emitting element of Example 1 or Example 2 which will be described later, the first regions 21 and the second regions 22 are periodically and alternately arranged, the effective refractive index $n_{eff-1}$ of the first region 21 is different from the effective refractive index $n_{eff-2}$ of the second region 22 (in particular, $n_{eff-1} > n_{eff-2}$ in Example 1), and in the first regions 21 and the second regions 22, the two types of laser light in a fundamental transverse mode are generated (oscillated). In this case, since $(P_1-P_2)=1$, and the value of $P_2$ is an integer of 2 or more, laser light in a fundamental transverse mode generated in one second region 22 reaches an adjacent second region 22 before coupling with laser light in a fundamental transverse mode generated in the first region 21 is completed. As a result, the two types of laser light in a fundamental transverse mode (light having a wavelength $\lambda_1$ and light having a wavelength $\lambda_2$) are present.

In addition, as a result, as the total light emitted from the semiconductor light emitting element, the value of the oscillation wavelength width $\Delta\lambda$ can be increased, and without using a complicated element structure and/or circuit, the reduction in speckle noise can be achieved by the semiconductor light emitting element itself. In addition, since the optical intensity distribution of laser light to be emitted is the normal distribution as described above, a highly fine image can be obtained.

Example 2

Example 2 is a modification of Example 1. As shown in Fig. 2B which is a schematic cross-sectional view similar to that taken along the arrows IB-IB shown in Fig. 1A, in Example 2, in the vicinity of the second region 22, a refractive index control region (a refractive index change region, a refractive index disturbance region, a disorder region, or a waveguide loss decrease region) 24 is formed which makes the effective refractive index $n_{eff-2}$ of the second region 22 different from the effective refractive index $n_{eff-1}$ of the first region 21 (in particular, $n_{eff-1} > n_{eff-2}$ in Example 2). In Example 2, in the refractive index control region 24, a metal film, in particular, a titanium (Ti) film, is formed. The refractive index control region 24 is formed on the second compound semiconductor layer 32 so as to be 1.5 $\mu$m apart from one side of the ridge portion 20. The length of the refractive index control region 24 along the extending direction of the optical waveguide (ridge portion 20) is 90 $\mu$m, and the width of the refractive index control region 24 is 20 $\mu$m. In addition, the effective refractive indexes of the first and the second regions are as follows.

$$n_{eff-1}=3.2700$$

$$n_{eff-2}=3.2666$$

Example 3

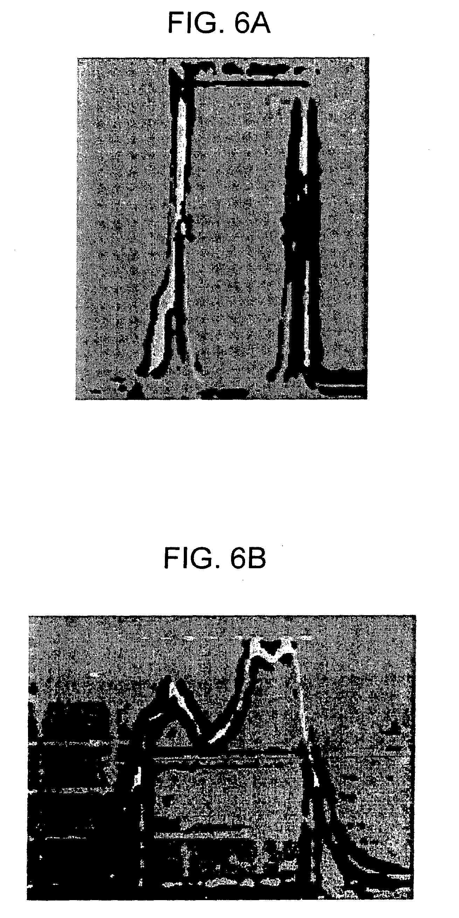

Example 3 is also a modification of Example 1. In Example 3, a predetermined drive current is allowed to pass through the first regions 21 and the second regions 22 of the optical waveguide, and in addition, a high frequency signal (such as 100 to 300 MHz, and in particular, 200 MHz in Example 3) is superimposed on the current. Accordingly, since the fluctuation in gain is generated, as shown in Figs. 6A and 6B, the value of $\Delta\lambda$ can be further increased, and the reduction in speckle noise can be more effectively achieved. In Fig. 6A, the case of continuous oscillation without the superimposition is shown, and in Fig. 6B, the case of continuous oscillation with the superimposition is shown. In particular, the value of $\Delta\lambda$ can be increased from 2.5 nm to approximately 4 nm in half bandwidth.

Example 4

Example 4 relates to the semiconductor light emitting element according to the second and the third embodiments of the present disclosure. A schematic arrangement view of constituents of the semiconductor light emitting element of Example 4 is shown in Fig. 7. In addition, a schematic cross-sectional view of the semiconductor light emitting element of Example 4 taken along the arrows A-A is similar to that shown in Fig. 2A.

The semiconductor light emitting element of Example 4 will be described with reference to the semiconductor light emitting element according to the second embodiment of the present disclosure. First regions 21 and second regions 22 are periodically and alternately arranged in an optical waveguide (ridge portion 20) along an extending direction thereof, and when the number of the first regions and the number of the second regions are represented by $P_1$ and $P_2$, respectively, if $(P_1-P_2)=1$ holds, $P_2$ is an integer of 2 or more, and if $(P_2-P_1)=1$ holds, $P_1$ is an integer of 2 or more. In addition, a width $W_1$ of the first region 21 is different from a width $W_2$ of the second region 22. In particular, in Example 4, $W_1<W_2$ holds. Alternatively, the semiconductor light emitting element of Example 4 will be described with reference to the semiconductor light emitting element according to the third embodiment of the present disclosure. First regions 21 and second regions 22 are periodically and alternately arranged in an optical waveguide (ridge portion 20) along an extending direction thereof, and when the number of the first regions and the number of the second regions are represented by $P_1$ and $P_2$, respectively, if $(P_1-P_2)=1$ holds, $P_2$ is an integer of 2 or more, and if $(P_2-P_1)=1$ holds, $P_1$ is an integer of 2 or more. In addition, two types of light in a fundamental transverse mode are emitted. In this case, in the semiconductor light emitting element of Example 4, one ridge portion 20 is also occupied with the first regions 21 and the second regions 22. In addition, when the width of the first region 21 and the width of the second region 22 are represented by $W_1$ and $W_2$, respectively, the following equation is satisfied.

$$1.2\leq W_2/W_1\leq 2.5$$

Except that the [Step-120] is not performed and that the shape of the ridge portion 20 is different from that formed in the [Step-110], the semiconductor light emitting element of Example 4 can be formed by a method similar to that for the semiconductor light emitting element of Example 1, and hence, detailed description is omitted.

In the semiconductor light emitting element of Example 4, since the widths of the first region 21 and the second regions 22, which are periodically and alternately arranged, are different from each other (in particular, in Example 4, $W_1<W_2$), a wavelength $\lambda_2$ of light in a fundamental transverse mode generated (oscillated) in the second region 22 is different from a wavelength $\lambda_1$ of light in a fundamental transverse mode generated (oscillated) in the first region 21, and in addition, two types of light in a fundamental transverse mode are generated in the first region 21 and the second region 22. In this case, since $(P_1-P_2)=2$ holds, and the value of $P_2$ is an integer of 2 or more, light in a fundamental transverse mode generated in one second region 22 reaches an adjacent second region 22 before coupling with light in a fundamental transverse mode generated in the first region 21 is completed. As a result, the two types of light in a fundamental transverse mode (light having a wavelength $\lambda_1$ and light having a wavelength $\lambda_2$) are present. In addition, as a result, as the total light emitted from the semiconductor light emitting element, the value of the oscillation wavelength width $\Delta\lambda$ can be increased, and without using a complicated element structure and/or circuit, the reduction in speckle noise can be achieved by the semiconductor light emitting element itself. In addition, according to the result of measurement, it is confirmed that the optical intensity distribution of total light to be emitted is the normal distribution, and hence, a highly fine image can be obtained.

In addition, the configuration and the structure of the semiconductor light emitting element of Example 4 may be used in combination with the configurations and the structures of the semiconductor light emitting elements described in Examples 1 to 3.

Example 5

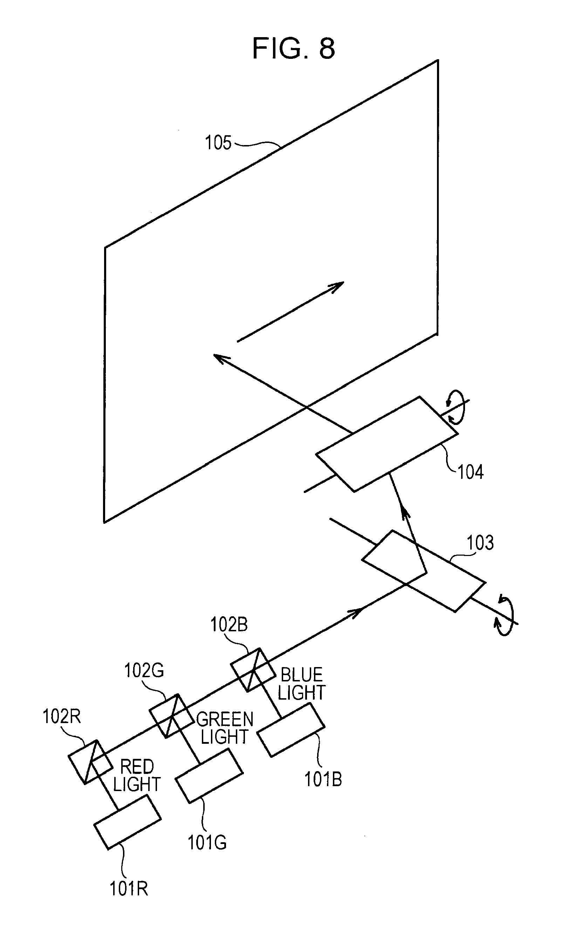

Example 5 relates to the display device according to the fourth embodiment of the present disclosure. In Example 5, as shown in a conceptual view of Fig. 8, as the display device, a raster scan type projector device having a semiconductor light emitting element as a light source will be described. In this projector device, laser light is raster scanned using a semiconductor light emitting element formed of a semiconductor laser element as a light source, and in accordance with an image to be displayed, the luminance of the laser light is controlled so as to display the image. In particular, after laser light from a red light emission semiconductor light emitting element 101R, laser light from a green light emission semiconductor light emitting element 101G, and laser light from a blue light emission semiconductor light emitting element 101B are collected into one laser beam by dichroic prisms 102R, 102G, and 102B, respectively, this laser beam is scanned by a horizontal scanner 103 and a vertical scanner 104 and is projected on a laser irradiation surface 105, such as a screen or a wall surface, on which various types of images are to be displayed, so that an image can be obtained. As the horizontal scanner 103 and the vertical scanner 104, for example, a polygon mirror and a galvano scanner may be used in combination. Alternatively, as the horizontal scanner and the vertical scanner, for example, a plurality of digital micromirror devices (DMDs) formed by using an MEMS technique may be used in combination with a polygon mirror or a galvano scanner, and the structure in which a horizontal scanner and a vertical scanner are integrated together may be formed from a two-dimensional space modulation element including DMDs arranged in a two-dimensional matrix or from a two-dimensional MEMS scanner performing a two-dimensional scan with one DMD. Furthermore, a refractive index modulation scanner, such as an acoustooptic effect scanner or an electrooptic effect scanner, may also be used.

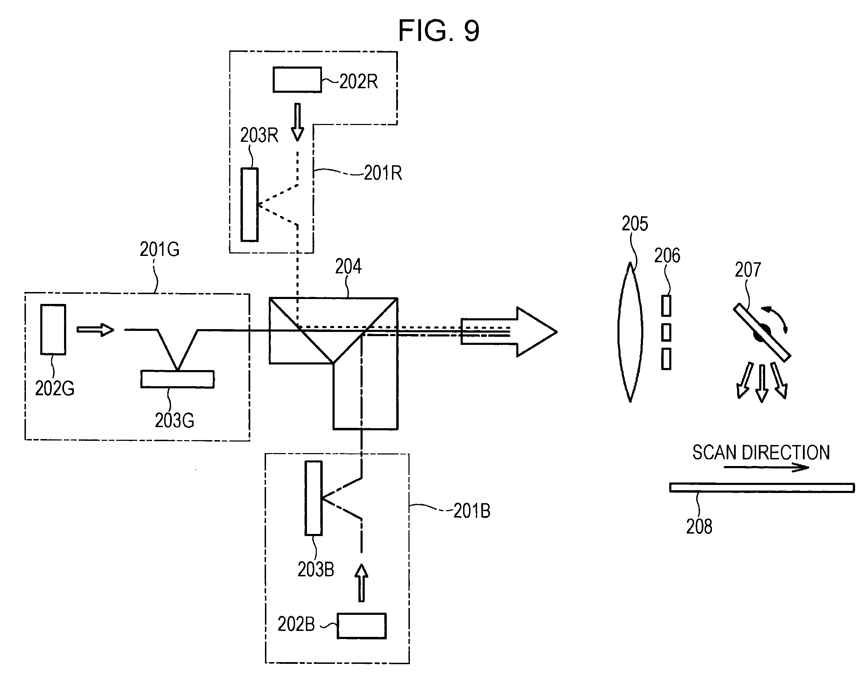

Alternatively, a plurality of grating light valve (GLV) elements each functioning as a one-dimensional modulation element may be used in combination with a polygon mirror or a galvano scanner. That is, as shown in a conceptual view of Fig. 9, the display device includes an image generation device 201R formed of a GLV element 203R and a laser light source (red light emitting semiconductor laser) 202R, an image generation device 201G formed of a GLV element 203G and a laser light source (green light emitting semiconductor laser) 202G, and an image generation device 201B formed of a GLV element 203B and a laser light source (blue light emitting semiconductor laser) 202B. In addition, red laser light emitted from the laser light source (red light emitting semiconductor laser) 202R is shown by a dotted line, green laser light emitted from the laser light source (green light emitting semiconductor laser) 202G is shown by a solid line, and blue laser light emitted from the laser light source (blue light emitting semiconductor laser) 202B is shown by a chain line. The display device further includes collective lenses (not shown) which collect laser light beams emitted from the respective laser light sources 202R, 202G, and 202B and which emit collected laser light beams to the respective GLV elements 203R, 203G, and 203B; an L type prism 204 on which the laser light beams emitted from the GLV elements 203R, 203G, and 203B are incident and which collects the laser light beams into one light flux; a lens 205 and a space filter 206, both of which allow the collected three primary-color laser light beams to pass therethrough; an imaging lens (not shown) which forms an image from one light flux passing through the space filter 206; a scan mirror (galvano scanner) 207 which scans one light flux passing through the imaging lens; and a screen (laser irradiation surface) 208 on which laser light scanned by the scan mirror 207 is projected.

Heretofore, although the present disclosure has been described with reference to the preferable examples, the present disclosure is not limited to the examples described above. The configurations and the structures of the semiconductor light emitting elements and the display device and the methods for manufacturing a semiconductor light emitting element of the examples have been described by way of example and may be appropriately changed and modified. For example, the wavelength $\lambda_1$ of light in a fundamental transverse mode to be generated in the first region, the wavelength $\lambda_2$ of light in a fundamental transverse mode to be generated in the second region, the average wavelength $\lambda_{ave}$ of light to be emitted, the maximum peak value $\lambda_{max}$ of the wavelength of light to be emitted, and the wavelength width $\Delta\lambda$ of light to be emitted may be determined based on the specifications necessary for the semiconductor light emitting element, and for example, the length $L_1$ of the first region along the extending direction of the optical waveguide, the length $L_2$ of the second region along the extending direction of the optical waveguide, the width $W_1$ of the first region, the width $W_2$ of the second region, the effective refractive index $n_{eff-1}$ of the first region, the effective refractive index $n_{eff-2}$ of the second region, the size of the refractive index control region, and the position at which the refractive index control region is provided may be appropriately determined based on the specifications necessary for the semiconductor light emitting element by performing various types of evaluation tests. Even when the active layer is formed from a GaInN-based compound semiconductor instead of using a GaInP-based compound semiconductor, the same results as described above can also be obtained.

In addition, in the semiconductor light emitting element according to an embodiment of the present disclosure, third regions may be further provided, and three types of light (light having a wavelength $\lambda_1$, light having a wavelength $\lambda_2$, and light having a wavelength $\lambda_3$) in a fundamental transverse mode may be allowed to be present. In particular, for example, a semiconductor light emitting element having an arrangement including the first region, the second region, the first region, the second region, the first region, the third region, the first region, the third region, and the first region in this order may be mentioned. In the examples, although the configuration including the first region, the second region, the first region, the second region, the first region, the second region, and the first region in this order has been described by way of example, for example, the configuration including the second region, the first region, the second region, the first region, the second region, the first region, and the second region in this order may also be used.

In the examples, although the semiconductor light emitting element is formed of a semiconductor laser element, from the compound semiconductor-laminate structure 30 (see Table 1) described in Example 1, a super luminescent diode (SLD) may also be formed. Although having an optical waveguide structure similar to that of the semiconductor laser element described in Example 1, the SLD has no oscillator structure unlike the semiconductor laser element. In the SLD, spontaneous emission light generated by current injection is amplified by stimulated emission while guided through an optical waveguide structure and is then emitted. The SLD as described above can be obtained when the optical reflectance at a light emission surface is set to be a very low value, and when the optical reflectance at a light reflection surface is set to be a very high value.

In addition, according to an embodiment of the present disclosure, the following structures may also be formed.

[1] <Semiconductor Light Emitting Element: First Embodiment>
A semiconductor light emitting element in which first regions and second regions are periodically and alternately arranged in an optical waveguide along an extending direction thereof; when the number of the first regions and the number of the second regions are represented by $P_1$ and $P_2$, respectively, if $(P_1-P_2)=1$, $P_2$ is an integer of 2 or more, and if $(P_2-P_1)=1$, $P_1$ is an integer of 2 or more; and the effective refractive index of the first region is different from the effective refractive index of the second region.

[2] The semiconductor light emitting element described in the above [1] which emits two types of light in a fundamental transverse mode.

[3] The semiconductor light emitting element described in the above [1] or [2] in which when the length of the first region along the extending direction of the optical waveguide is represented by $L_1$, the average wavelength of light to be emitted is represented by $\lambda_{ave}$, the effective refractive index of the first region is represented by $n_{eff-1}$, and the effective refractive index of the second region is represented by $n_{eff-2}$, the following equation is satisfied.

$$0.7 \times \{\lambda_{ave}/(n_{eff-1}- n_{eff-2})\} \leq L_1 \leq 1.3 \times \{\lambda_{ave}/(n_{eff-1}- n_{eff-2})\}$$

[4] The semiconductor light emitting element described in one of the above [1] to [3] in which when the total length of the first regions along the extending direction of the optical waveguide is represented by $L_1$, and the total length of the second regions along the extending direction of the optical waveguide is represented by $L_2$, the following equation is satisfied.

$$0.1 \leq L_2/(L_1+L_2) \leq 0.4$$

[5] The semiconductor light emitting element described in one of the above [1] to [4] in which when the effective refractive index of the first region is represented by $n_{eff-1}$, and the effective refractive index of the second region is represented by $n_{eff-2}$, the following equation is satisfied.

$$1 \times 10^{-3} \leq (n_{eff-1}- n_{eff-2})/n_{eff-1} \leq 1 \times 10^{-2}$$

[6] The semiconductor light emitting element described in one of the above [1] to [5] in which when the maximum peak value of the wavelength of light to be emitted from the semiconductor light emitting element is represented by $\lambda_{max}$, and the wavelength width of the light is represented by $\Delta\lambda$, the following equation is satisfied.

$$\Delta\lambda/\lambda_{max} \geq 1.5 \times 10^{-4}$$

[7] The semiconductor light emitting element described in one of the above [1] to [6] in which one ridge portion is occupied with the first regions and the second regions, and in order to make the effective refractive index of the second region different from the effective refractive index of the first region, refractive index control regions are each provided in the vicinity of the second region.

[8] The semiconductor light emitting element described in the above [7] in which the refractive index control regions each contain a substance decreasing the refractive index.

[9] The semiconductor light emitting element described in the above [8] in which the substance decreasing the refractive index includes zinc oxide.

[10] The semiconductor light emitting element described in the above [7] in which a metal film is formed in the refractive index control region.

[11] The semiconductor light emitting element described in the above [10] in which the metal film includes titanium, platinum, or gold.

[12] <Semiconductor Light Emitting Element: Second Embodiment>
A semiconductor light emitting element in which first regions and second regions are periodically and alternately arranged in an optical waveguide along an extending direction thereof; when the number of the first regions and the number of the second regions are represented by $P_1$ and $P_2$, respectively, if $(P_1-P_2)=1$, $P_2$ is an integer of 2 or more, and if $(P_2-P_1)=1$, $P_1$ is an integer of 2 or more; and the width of the first region is different from the width of the second region.

[13] The semiconductor light emitting element described in the above [12] which emits two types of light in a fundamental transverse mode.

[14] The semiconductor light emitting element described in the above [12] or [13] in which when the width of the first region is represented by $W_1$, and the width of the second region is represented by $W_2$, the following equation is satisfied.

$$1.2 \leq W_2/W_1 \leq 2.5$$

[15] The semiconductor light emitting element described in one of the above [12] to [14] in which when the total length of the first regions along the extending direction of the optical waveguide is represented by $L_1$, and the total length of the second regions along the extending direction of the optical waveguide is represented by $L_2$, the following equation is satisfied.

$$0.1 \leq L_2/(L_1+L_2) \leq 0.4$$

[16] The semiconductor light emitting element described in one of the above [12] to [15] in which when the maximum peak value of the wavelength of light to be emitted from the semiconductor light emitting element is represented by $\lambda_{max}$, and the wavelength width of the light is represented by $\Delta\lambda$, the following equation is satisfied.

$$\Delta\lambda/\lambda_{max} \geq 1.5 \times 10^{-4}$$

[17] The semiconductor light emitting element described in one of the above [12] to [16] in which one ridge portion is occupied with the first regions and the second regions.

[18] The semiconductor light emitting element described in one of the above [12] to [17] in which the effective refractive index of the first region is different from the effective refractive index of the second region.

[19] The semiconductor light emitting element described in the above [18] in which when the length of the first region along the extending direction of the optical waveguide is represented by $L_1$, the average wavelength of light to be emitted is represented by $\lambda_{ave}$, the effective refractive index of the first region is represented by $n_{eff-1}$, and the effective refractive index of the second region is represented by $n_{eff-2}$, the following equation is satisfied.

$$0.7 \times \{\lambda_{ave}/(n_{eff-1}- n_{eff-2})\} \leq L_1 \leq 1.3 \times \{\lambda_{ave}/(n_{eff-1}- n_{eff-2})\}$$

[20] The semiconductor light emitting element described in the above [18] or [19] in which when the effective refractive index of the first region is represented by $n_{eff-1}$, and the effective refractive index of the second region is represented by $n_{eff-2}$, the following equation is satisfied.

$$1 \times 10^{-3} \leq (n_{eff-1}- n_{eff-2})/n_{eff-1} \leq 1 \times 10^{-2}$$

[21] The semiconductor light emitting element described in one of the above [18] to [20] in which in order to make the effective refractive index of the second region different from the effective refractive index of the first region, refractive index control regions are each provided in the vicinity of the second region.

[22] The semiconductor light emitting element described in the above [21] in which the refractive index control regions each contain a substance decreasing the refractive index.

[23] The semiconductor light emitting element described in the above [22] in which the substance decreasing the refractive index includes zinc oxide.

[24] The semiconductor light emitting element described in the above [21] in which a metal film is formed in the refractive index control region.

[25] The semiconductor light emitting element described in the above [24] in which the metal film includes titanium, platinum, or gold.

[26] <Semiconductor Light Emitting Element: Third Embodiment>

A semiconductor light emitting element in which first regions and second regions are periodically and alternately arranged in an optical waveguide along an extending direction thereof; when the number of the first regions and the number of the second regions are represented by $P_1$ and $P_2$, respectively, if $(P_1-P_2)=1$, $P_2$ is an integer of 2 or more, and if $(P_2-P_1)=1$, $P_1$ is an integer of 2 or more; and two types of light in a fundamental transverse mode are emitted.

[27] The semiconductor light emitting element described in the above [26] in which when the total length of the first regions is represented by $L_1$, and the total length of the second regions is represented by $L_2$, the following equation is satisfied.

$$0.1 \leq L_2/(L_1+L_2) \leq 0.4$$

[28] The semiconductor light emitting element described in the above [26] or [27] in which when the maximum peak value of the wavelength of light to be emitted from the semiconductor light emitting element is represented by $\lambda_{max}$, and the wavelength width of the light is represented by $\Delta\lambda$, the following equation is satisfied.

$$\Delta\lambda/\lambda_{max} \geq 1.5 \times 10^{-4}$$

[29] The semiconductor light emitting element described in one of the above [26] to [28] in which one ridge portion is occupied with the first regions and the second regions.

[30] The semiconductor light emitting element described in one of the above [1] to [29] in which a predetermined drive current is allowed to pass through the first regions and the second regions, and a high frequency signal is superimposed on the current.

[31] The semiconductor light emitting element described in one of the above [1] to [30] in which the optical waveguide is provided with an active layer, and the active layer is formed from an AlGaInP-based compound semiconductor.

[32] The semiconductor light emitting element described in the above [31] in which the active layer has a multiquantum well structure including well layers each formed of a GaInP layer or an AlGaInP layer and barrier layers each formed of an AlGaInP layer, the well layers and the barrier layers being laminated to each other.

[33] The semiconductor light emitting element described in one of the above [1] to [30] in which the optical waveguide is provided with an active layer, and the active layer is formed from a GaInN-based compound semiconductor.

[34] The semiconductor light emitting element described in the above [33] in which the active layer has a multiquantum well structure including well layers each formed of a GaInN layer and barrier layers each formed of a GaInN layer having a different In composition from that of each of the well layers, the well layers and the barrier layers being laminated to each other.

[35] The semiconductor light emitting element described in one of the above [1] to [34] which is formed of a semiconductor laser element or a super luminescent diode.

[36] <Display Device: Fourth Embodiment>

A display device including the semiconductor light emitting element described in one of the above [1] to [35].

It should be understood by those skilled in the art that various modifications, combinations, sub-combinations and alterations may occur depending on design requirements and other factors insofar as they are within the scope of the appended claims or the equivalents thereof.

**Claims**

1. A semiconductor light emitting element comprising:

   first regions; and
   second regions, the first regions and the second regions being periodically and alternately arranged in an optical waveguide along an extending direction thereof,
   wherein when the number of the first regions and the number of the second regions are represented by $P_1$ and $P_2$, respectively, if $(P_1-P_2)=1$, $P_2$ is an integer of 2 or more, and if $(P_2-P_1)=1$, $P_1$ is an integer of 2 or more, and an effective refractive index of the first region is different from an effective refractive index of the second region.

2. The semiconductor light emitting element according to Claim 1,
   wherein the semiconductor light emitting element emits two types of light in a fundamental transverse mode.

3. The semiconductor light emitting element according to any of the preceding claims,

wherein when the length of the first region along the extending direction of the optical waveguide is represented by $L_1$, the average wavelength of light to be emitted is represented by $\lambda_{ave}$, the effective refractive index of the first region is represented by $n_{eff-1}$, and the effective refractive index of the second region is represented by $n_{eff-2}$, the following equation is satisfied

$$0.7 \times \{\lambda_{ave}/(n_{eff-1} - n_{eff-2})\} \leq L_1 \leq 1.3 \times \{\lambda_{ave}/(n_{eff-1} - n_{eff-2})\}.$$

4. The semiconductor light emitting element according to any of the preceding claims,
wherein when the effective refractive index of the first region is represented by $n_{eff-1}$, and the effective refractive index of the second region is represented by $n_{eff-2}$, the following equation is satisfied

$$1 \times 10^{-3} \leq (n_{eff-1} - n_{eff-2})/n_{eff-1} \leq 1 \times 10^{-2}.$$

5. The semiconductor light emitting element according to any of the preceding claims,
wherein the first regions and the second region form one ridge portion,
further comprising refractive index control regions in the vicinities of the second regions in order to make the effective refractive index of the second region different from the effective refractive index of the first region.

6. The semiconductor light emitting element according to Claim 5,
wherein the refractive index control regions each contain a substance decreasing the refractive index.

7. The semiconductor light emitting element according to Claim 5,
wherein the refractive index control regions each include a metal film.

8. A semiconductor light emitting element comprising:

first regions; and
second regions, the first regions and the second regions being periodically and alternately arranged in an optical waveguide along an extending direction thereof,
wherein when the number of the first regions and the number of the second regions are represented by $P_1$ and $P_2$, respectively, if $(P_1-P_2)=1$, $P_2$ is an integer of 2 or more, and if $(P_2-P_1)=1$, $P_1$ is an integer of 2 or more, and the width of the first region is different from the width of the second region.

9. The semiconductor light emitting element according to Claim 8,
wherein the semiconductor light emitting element emits two types of light in a fundamental transverse mode.

10. The semiconductor light emitting element according to Claim 8 or 9,
wherein when the width of the first region is represented by $W_1$, and the width of the second region is represented by $W_2$, the following equation is satisfied

$$1.2 \leq W_2/W_1 \leq 2.5.$$

11. A semiconductor light emitting element comprising:

first regions; and
second regions, the first regions and the second regions being periodically and alternately arranged in an optical waveguide along an extending direction thereof,
wherein when the number of the first regions and the number of the second regions are represented by $P_1$ and $P_2$, respectively, if $(P_1-P_2)=1$, $P_2$ is an integer of 2 or more, and if $(P_2-P_1)=1$, $P_1$ is an integer of 2 or more, and the semiconductor light emitting element emits two types of light in a fundamental transverse mode.

12. The semiconductor light emitting element according to any of the preceding claims,
wherein the first regions and the second regions of the optical waveguide allows a predetermined drive current to pass therethrough, and

the current is superimposed by a high frequency signal.

13. The semiconductor light emitting element according to any of the preceding claims,
    wherein the optical waveguide is provided with an active layer, and
    the active layer includes an AlGaInP-based compound semiconductor.

14. The semiconductor light emitting element according to Claim 13,
    wherein the active layer has a multiquantum well structure comprising
    well layers each formed of a GaInP layer or an AlGaInP layer, and
    barrier layers each formed of an AlGaInP layer, the well layers and the barrier layers being laminated to each other.

15. A display device including the semiconductor light emitting element according to any of the preceding claims.

## FIG. 1A

## FIG. 1B

# FIG. 2A

# FIG. 2B

# FIG. 3A

# FIG. 3B

# FIG. 4A

# FIG. 4B

## FIG. 5A

## FIG. 5B

# FIG. 6A

# FIG. 6B

# FIG. 7

# FIG. 8

# FIG. 9

EP 2 770 592 A2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013034821 A
- JP 2009025462 A
- JP 2010171316 A